# EUROPÄISCHE PATENTSCHRIFT

(11) **EP 0 970 899 B1**
(45) Veröffentlichungstag und Bekanntmachung des Hinweises auf die Patenterteilung: **31.03.2004**
(21) Anmeldenummer: 99112429.8
(22) Anmeldetag: 30.06.1999
(51) Int. Cl.: B65G 49/04

(54) **Verfahren und Vorrichtung zum Behandeln von scheibenförmigen Gegenständen wie Blechen, Glasplatten, Leiterplatten, Keramiksubstraten**
Method and device for processing slice-shaped articles like plates, panes of glass, circuit boards, ceramic substrates
Procédé et appareil pour traiter des objets en forme de tranches comme des tôles, vitres, circuits imprimés, substrats céramiques

(30) Priorität: 07.07.1998 DE 19830212
(43) Veröffentlichungstag der Anmeldung: 12.01.2000
(73) Patentinhaber: RWE SCHOTT Solar GmbH, 63755 Alzenau (DE)
(72) Erfinder: Wandel, Gernot, Dr., 89143 Blaubeuren-Steigziegelhütte (DE); Heyer, Fritz, 22880 Wedel (DE); Schum, Berthold, 63599 Biebergemünd (DE)
(74) Vertreter: Stoffregen, Hans-Herbert, Dr. Dipl.-Phys.

(56) Entgegenhaltungen:
- EP-A- 0 070 694
- EP-A- 0 520 895
- DE-A- 3 543 286
- DE-A- 4 038 587
- DE-C- 639 104
- DE-U- 7 316 859
- FR-A- 1 032 599

## Beschreibung

Die Erfindung bezieht sich auf ein Verfahren zum Behandeln von scheibenförmigen Gegenständen wie Blechen, Glasplatten, Leiterplatten, Keramiksubstraten, wobei die Gegenstände einem Flüssigkeit enthaltenden Bad zugeführt werden, mittels einer Dreheinrichtung bei bleibender Ausrichtung der Gegenstände zur Drehachse der Dreheinrichtung um diese gedreht und dabei durch das Bad transportiert und nach dem Bad translatorisch weggeführt werden, wobei die Gegenstände während ihres Transportes durch das Bad in in Bezug auf die Drehachse radial verlaufende Aufnahmen der Dreheinrichtung durch eine diese peripher umgebende Sicherung zurückgehalten werden. Auch bezieht sich die Erfindung auf eine Vorrichtung zum Behandeln von scheibenförmigen Gegenständen wie Blechen, Glasplatten, Leiterplatten, Keramiksubstraten, umfassend ein mit Flüssigkeit befüllbares Bad wie chemisches Bad zum Behandeln der Gegenstände, eine dem Bad vorgeordnete Zuführeinrichtung, eine die Gegenstände durch das Bad führende Fördereinrichtung in Form einer Dreheinrichtung mit radial verlaufenden zur Aufnahme der Gegenstände bestimmten Aufnahmen, eine innerhalb des Bades vorhandene Sicherung, die sich im peripheren Bereich der Aufnahmen zum Zurückhalten der Gegenstände in den Aufnahmen erstreckt, eine dem Bad nachgeordnete Entnahmeeinrichtung sowie dem Bad nachgeordnete Wasch- und/oder Trocknungsstufe mit zugeordneter Transporteinrichtung.

Um zum Beispiel Oxidschichten von Halbleiterscheiben durch Abätzen in verdünnter Flusssäure zu behandeln, ist es bekannt, die Scheiben in Horden aus Kunststoff zu stellen und diese sodann manuell oder mit einem Handhabungsgerät nacheinander in verschiedene chemische Bäder zu tauchen oder mit Chemikalien zu besprühen. Nachteil dieser Verfahrensweise ist es, dass das Einstellen der Scheiben in die Horden und das Herausnehmen der Scheiben aus diesen zusätzliche Verfahrensschritte erforderlich machen, die insbesondere dann unerwünscht sind, wenn die der chemischen Behandlung vorhergehenden oder nachfolgenden Prozesse kontinuierlich ablaufen sollen.

Nachteil des bekannten Verfahrens ist es des Weiteren, dass die Zufuhr der Chemikalien zu den zu behandelnden Scheiben durch die Horden eingeschränkt wird. Ferner können beim Trocknen Flüssigkeit wie Wasser sowie Chemikalienreste in den Taschen der Horden verbleiben, sofern nicht aufwendige Trockungsverfahren zur Anwendung gelangen.

Bei einem anderen bekannten Verfahren werden die Scheiben mittels eines Riemenförderers oder Tansportbandes durch eine Sprühvorrichtung geführt, in der ein Besprühen mit Chemikalien erfolgt. Durch das Besprühen ist nicht sichergestellt, dass einerseits die Scheiben vollständig benetzt werden und andererseits ist die Behandlungsdauer eingeschränkt bzw. die benötigten Anlagen müssen sehr voluminös ausgebildet sein.

Der DE-PS 639 104 ist eine Vorrichtung zum Behandeln von Blechen zu entnehmen, die durch ein mit Flüssigkeit gefülltes Bad geführt werden. Dabei werden die flächigen Gegenstände von einer Dreheinrichtung aufgenommen und durch das Bad geführt. Hinter dem Bad befindet sich eine Transportvorrichtung, mit der die Gegenstände translatorisch bewegt werden. Der Dreheinrichtung selbst werden die Gegenstände von einem Stapel zugeführt. Des Weiteren verlaufen peripher zu der Dreheinrichtung stationäre Führungsleisten, entlang der die Bleche gleiten, um sicherzustellen, dass die Bleche in der Dreheinrichtung verbleiben.

Aus der EP 0 070 694 A1 ist eine Transportvorrichtung bekannt, bei der Gegenstände wie Fassungen mittels eines Drehtellers transportiert werden, die umfangsseitig von einem Endlosband umgeben ist. Der Drehteller selbst ist um eine vertikal verlaufende Drehachse drehbar. Die Gegenstände werden im Eingangsbereich des Drehtellers relativ zu einer feststehenden Führungsplatte bewegt.

Eine der DE-OS 1 951 200 zu entnehmende Speichenrad-Transportvorrichtung sieht eine Fördereinrichtung in Form eines Speichenrades vor, um Brammen zu kühlen.

Ein Verfahren zur Metallisierung von Oberflächen flacher Gegenstände wird in der DE 35 43 286 C2 beschrieben. Dabei durchlaufen die Gegenstände mehrere Reinigungs- und Trockenstationen.

Aus der EP 0 637 561 A1 ist eine Vorrichtung zum Umsetzen von Leiterplatten bekannt, bei der ein Drehrad in Form eines Fächerspeichers benutzt wird. Dabei werden die Gegenstände translatorisch zu dem Fächerspeicher und in diesem oberhalb der Drehachse transportiert.

Aus der FR 1 032 599 sind ein Verfahren und eine Vorrichtung zum Reinigen von stabförmigen Elementen bekannt, die mittels einer Dreheinrichtung durch ein Bad geführt werden. Dabei werden die Elemente in die Dreheinrichtung abgeworfen. Nach einem Ausführungsbeispiel wird die Dreheinrichtung über z. B. eine diese peripher teilweise umgebende Kette angetrieben.

Der vorliegenden Erfindung liegt das Problem zu Grunde, ein Verfahren und eine Vorrichtung der eingangs genannten Art so weiterzubilden, dass neben einer Integration in einen kontinuierlichen Prozess sichergestellt ist, dass die Gegenstände im erforderlichen Umfang mit der zur Behandlung erforderlichen Flüssigkeit beaufschlagt werden können, ohne dass eine Beschädigung erfolgt. Insbesondere sollen Relativbewegungen zwischen den Gegenständen und der Dreheinrichtung beim Führen der Gegenstände durch das Bad unterbunden werden.

Erfindungsgemäß wird das Problem durch ein Verfahren dadurch gelöst, dass die Gegenstände während ihres Transportes durch das Bad mittels eines flexiblen Elementes als Sicherung in der Aufnahme zurückgehalten werden, das synchron mit der Dreheinrichtung bewegt wird, dass die Gegenstände über ein erstes Transportband der Dreheinrichtung horizontal zugeführt werden, dass die Gegenstände über ein zweites Transportband von der Dreheinrichtung horizontal weggeführt und zumindest einer Wasch- und/oder Trokkenstufe zugeführt werden und dass die Gegenstände von dem ersten Transportband an die Aufnahmen und von diesen mittels eines Mitnehmers übergeben bzw. entnommen werden, wobei der Mitnehmer parallel zur Förderrichtung des ersten und zweiten Transportbandes bewegt und angehoben und abgesenkt wird.
Dabei werden die Gegenstände in zu der Drehachse radial verlaufenden Aufnahmen einer Drehfördereinrichtung eingebracht, wobei die Gegenstände während der Führung durch das Bad drehachsenabgewandt gesichert sind. Die Gegenstände selbst können der Drehfördereinrichtung wie Wenderad über ein Transportband wie Riemenförderer zugeführt und/oder von diesem weggeführt werden. Die Sicherung erfolgt über ein synchron mit der Drehfördereinrichtung sich mitbewegendes und diese innerhalb des Bodens peripher umgebendes flexibles Element, wodurch eine Relativbewegung zwischen den Gegenständen und der Sicherung und damit eine ansonsten mögliche Beschädigung von dünnen Gegenständen unterbunden wird.

Erfindungsgemäß erfolgt in einem kontinuierlichen oder quasi kontinuierlichen Prozess eine Übergabe der Gegenstände von einer ersten Fördereinrichtung wie Riemenförderer auf die Dreheinrichtung, welche als modifiziertes Wenderad bezeichnet werden kann, mittels der die Gegenstände durch das Bad geführt werden, um sodann an eine weitere translatorische Fördereinrichtung wie Transportband oder Riemenförderer übergeben zu werden. Sodann können die Gegenstände einer Wasch- und/oder Trocknungsstufe zugeführt werden.

Um in der Wasch- und/oder Trocknungsstufe sicherzustellen, dass sämtliche Bereiche der Gegenstände im erforderlichen Umfang gereinigt bzw. getrocknet werden, sieht eine Weiterbildung der Erfindung vor, dass die Gegenstände während ihres Transports durch die Wasch- und/oder Trocknungsstufe im Bereich ihrer Transportstrecke in unterschiedlichen Bereichen abgestützt werden. Mit anderen Worten weichen die Abstützpunkte der Gegenstände während ihres Transports durch die Wasch- und/oder Trocknungsstufe voneinander ab.

Um eine unkontrollierte Bewegung der Gegenstände während der Förderung durch die Wasch- und/oder Trocknungsstufe auszuschließen, ist des Weiteren vorgesehen, dass die Gegenstände in Richtung ihrer Abstützung druckbeaufschlagt werden.

Eine Vorrichtung der eingangs genannten Art zeichnet sich dadurch aus, dass die Sicherung ein sich synchron mit der Dreheinrichtung bewegendes flexibles Element ist, dass die Zuführeinrichtung ein erstes Transportband und die Entnahmeeinrichtung ein zweites Transportband sind und dass parallel zur Förderrichtung des ersten und des zweiten Transportbandes ein hin- und herbewegbarer sowie anheb- und absenkbarer die Gegenstände in die Aufnahmen aufgebender bzw. aus diesen entnehmender Mitnehmer angeordnet ist.

Dabei umfasst die Dreheinrichtung insbesondere zwei zueinander beabstandete von einer von der Achse durchsetzten gemeinsamen Welle ausgehende Wangen mit in Bezug auf die Achse radial zur Peripherie hin geöffnete Schlitze als Aufnahmen.

Die Wangen selbst sind vorzugsweise als Kreisscheiben ausgebildet und weisen Durchbrechungen auf.

Außenseitig entlang jeder Wange -sollte ein von der Welle ausgehendes seitliches Rückhalteelement wie Begrenzungsscheibe angeordnet sein, die vorzugsweise mit der jeweiligen Wange verbunden ist. Die entsprechenden Rückhalteelemente stellen sicher, dass die Gegenstände innerhalb der Schlitze nicht in unzulässigem Umfang axial verschiebbar sind. Damit die Gegenstände aus den Schlitzen während des Transportes durch das Bad radial nicht herausgleiten können, ist erfindungsgemäß zur Sicherung das umfangsseitig entlang der Wange wie Kreisscheibe die Aufnahme achsenabgewandt abdeckende flexible Element wie Riemen vorgesehen, das synchron mit der Dreheinrichtung mitbewegt wird. Dabei ist das flexible Element insbesondere ein Endlosriemen, der über Umlenkrollen zum randseitigen Anliegen an den Wangen in dem Bad geführt wird. Durch die synchronen Bewegungen kann eine Relativbewegung zwischen der Sicherung und den Gegenständen während ihres Transports durch das Bad nicht erfolgen. Somit ist insbesondere bei dünnen und/oder empfindlichen Gegenständen wie Glasplatten oder Keramiksubstraten sichergestellt, dass eine Beschädigung oder Zerstörung unterbleibt.

Um einen hohen Durchsatz zu erzielen, können von der Welle zumindest zwei Dreheinrichtungen ausgehen, wobei zwischen benachbarten Wangen von aufeinanderfolgenden Dreheinrichtungen jeweils ein Rückhalteelement verläuft. Hierdurch wird eine vorrichtungsmäßige Vereinfachung erzielt.

Die als radial verlaufende Schlitze ausgebildeten Aufnahmen für die Gegenstände sind insbesondere peripher gleichmäßig auf der Wange der Scheibe verteilt angeordnet. Auch besteht die Möglichkeit, dass die Vorrichtung mehrere in Reihe hintereinander angeordnete Bäder mit durch diese die Gegenstände fördernden Dreheinrichtungen umfasst.

Die Zuführeinrichtung zu der als Wenderad zu bezeichnenden Dreheinrichtung und/oder die der Dreheinrichtung nachgeordnete Entnahmeeinrichtung sollte eine translatorische Transporteinrichtung wie Riemenförderer sein.

Um die Gegenstände von der Zuführeinrichtung bzw. Entnahmeeinrichtung auf die Dreheinrichtung aufzugeben bzw. von dieser zu entnehmen, kann entweder die jeweilige Transporteinrichtung während der Übergabe bzw. Entnahme in den Bereich zwischen den Seitenwangen der Dreheinrichtung verschoben werden. Nach Abgabe bzw. Aufnahme der Gegenstände wird sodann die entsprechende Transporteinrichtung zurückgezogen.

Die Gegenstände werden von der Zuführeinrichtung auf die Dreheinrichtung bzw. von dieser auf die Entnahmeeinrichtung über den zumindest einen parallel zur Fördereinrichtung und zu dieser hin- und herbewegbaren Mitnehmer erfasst der vorzugsweise zwischen den Wangen einer Dreheinrichtung verläuft. Zum Erfassen ist der Mitnehmer des Weiteren anheb- bzw. absenkbar.

Durch die Verwendung des als Schieber zu bezeichnenden Mitnehmers können die Gegenstände problemlos in die Dreheinrichtung hinein bzw. aus dieser herausgeschoben werden, wobei die jeweils zugeordneten Transporteinrichtungen stirnseitig beabstandet zum peripheren Bereich der Wangen angeordnet sind. Hierdurch ergibt sich auch der Vorteil, dass die Mitnehmer bzw. Schieber nicht in Kontakt mit der Flüssigkeit kommen, so dass keine Verschleppung von insbesondere Chemikalien über die Transporteinrichtungen ausserhalb des Bades zu befürchten ist.

In der dem Bad nachgeordneten Reinigungs- und/oder Trocknungsstufe sollten die Gegenstände stände ebenfalls über eine translatorische Fördereinrichtung wie Riemenförderer oder Hubbalkenförderer bewegt werden. Dabei ist jede Fördereinrichtung in Förderabschnitte unterteilt, auf denen die Gegenstände in unterschiedlichen Bereichen abgestützt sind. Hierdurch ergibt sich der Vorteil, dass ein vollständiges Reinigen bzw. Trocknen der Gegenstände während des Durchlaufens durch die Reinigungs- bzw. Trocknungsstufe gewährleistet ist.

Um ein seitliches Ausweichen der Gegenstände auszuschließen, sieht eine Weiterbildung vor, dass die Gegenstände in der Transportstrecke seitlich von parallel zu dieser verlaufenden Führungselementen begrenzt sind.

Um ein Anheben der Gegenstände während des Beaufschlagens mit Reinigungsflüssigkeit und/oder Trocknungsluft zu unterbinden, können oberhalb der Transportstrecke der Reinigungs- und/oder Trocknungsstufe auf die Fördereinrichtung ausgerichtete Rollen angeordnet sein, über die die Gegenstände druckbeaufschlagt werden.

In der Transportstrecke der Reinigungsstufe sind auf die Gegenstände gerichtete Sprühdüsen und/oder Schwalleinrichtungen angeordnet, um auf einfachem Wege die erforderliche Reinigung zu erzielen. Dabei kann die Reinigungsstufe selbst mehrstufig ausgebildet sein. Die für jede Reinigungsstufe benötigte Reinigungsflüssigkeit strömt in einem Kreislauf, wobei Kreisläufe für gleiche Reinigungsflüssigkeiten in Kaskade geschaltet sind.

Die Trocknungsstufe selbst weist insbesondere Luftdüsen wie -messer auf, die auf die zu trocknenden Gegenstände ausgerichtet sind.

Um Flüssigkeit abzusaugen, kann der Transportstrecke zumindest eine Saugeinrichtung zugeordnet sein.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung von der Zeichnung zu entnehmenden bevorzugten Ausführungsbeispielen.

Es zeigen:
- Fig. 1: eine Prinzipdarstellung einer Fördereinrichtung zum Fördern von flächigen Substraten durch ein Bad,
- Fig. 2: einen Querschnitt durch eine mehrere Fördereinrichtungen gemäß Fig. 1 umfassende Anordnung und
- Fig 3: eine dem Bad gemäß Fig. 1 nachgeordnete Förderstrecke zum Reinigen und Trocknen von Gegenständen in prinzipieller Darstellung.

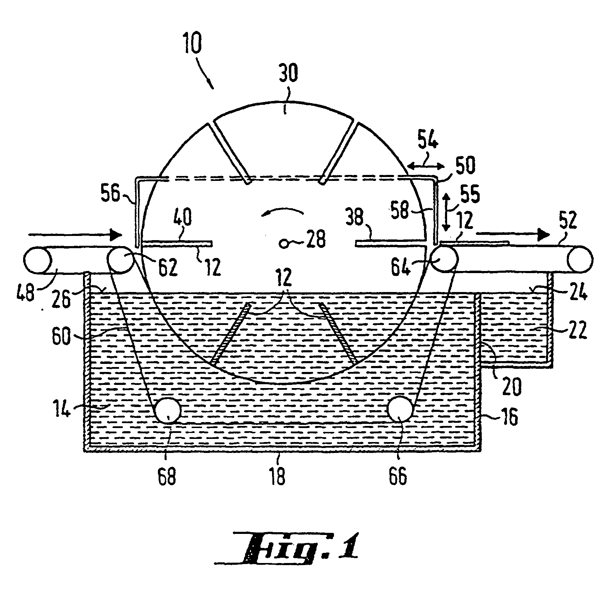

In Fig. 1 ist eine Prinzipdarstellung einer Fördereinrichtung 10 dargestellt, mittels der Gegenstände 12 durch ein eine Flüssigkeit 14 enthaltendes Bad 16 gefördert werden sollen, um z. B. Oberflächen abzuätzen. Dies ist zum Beispiel bei Halbleiterscheiben als flächige Gegenstände 12 mittels verdünnter Flusssäure möglich. Hierauf ist jedoch die erfindungsgemäße Lehre nicht beschränkt. Vielmehr erstreckt sich diese auf beliebige plattenförmige Gegenstände wie Bleche, Glasplatten, Leiterplatten, Kermamiksubstrate usw.

Das Bad 16 umfasst ein Becken 18, das über eine Trennwand 20 mit einem Vorlagetank 22 verbunden ist, von der die Flüssigkeit fortwährend umgewälzt wird, wobei der Flüssigkeitsspiegel 24 durch den oberen Rand der Trennwand 20 vorgegeben wird. Hierdurch ist sichergestellt, dass in dem Bad 18 stets der gleiche Flüssigkeitsspiegel 26 vorliegt.

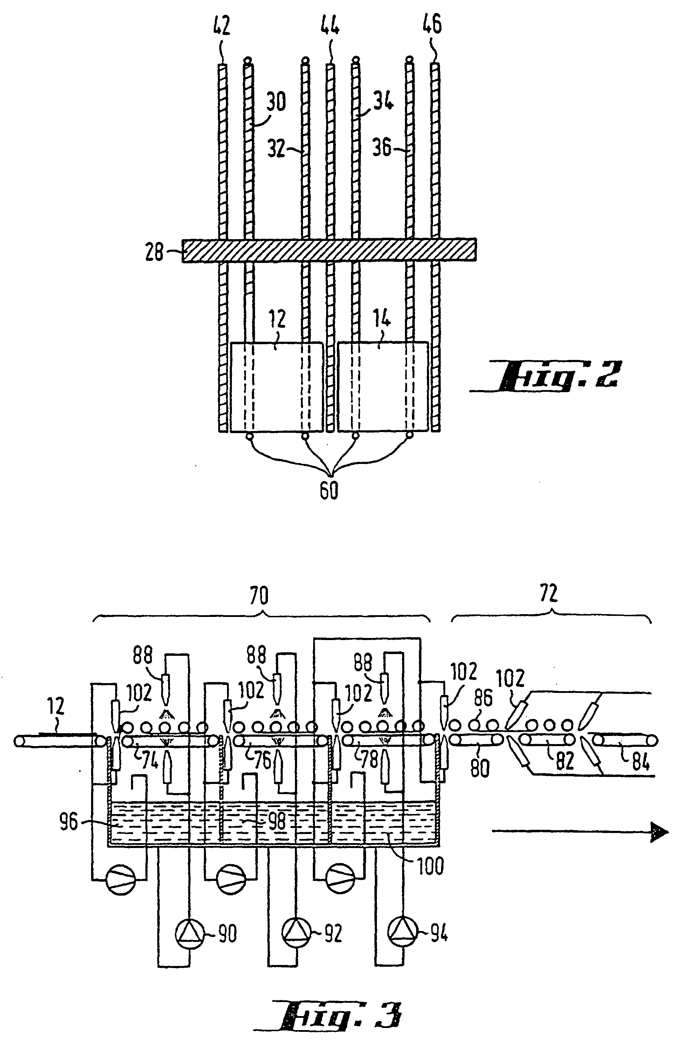

Innerhalb des Bades 16, also der Flüssigkeit 14 erstreckt sich die Fördereinrichtung 10, die als "Wenderad" ausgebildet ist. Dies bedeutet, dass von einer Welle 28 zueinander beabstandete scheibenförmige Elemente 30, 32 bzw. 34, 36 (Fig. 2) ausgehen, die um durch die Welle 28 vorgegebene Achse gemeinsam drehbar sind. Peripher vom Umfang der Scheiben 32, 34, 36 gehen radial verlaufende Schlitze aus, die beispielhaft mit den Bezugszeichen 38, 40 versehen sind. Die Schlitze 38, 40 dienen als Aufnahmen für die Gegenstände 12, die durch das Bad 18 gefördert und dort behandelt werden sollen. Wie die Schnittdarstellung gemäß Fig. 2 verdeutlicht, verlaufen außenseitig entlang jeder als Wange zu bezeichnenden Trägerscheibe 30, 32, 34, 36 seitliche scheibenförmige Rückhalte- oder Begrenzungselemente 42, 44, 46, die sicherstellen, dass in den Schlitzen 38, 40 vorhandene Gegenstände 12 axial nicht derart aus den Schlitzen 38, 40 herausrutschen können, dass diese nicht mehr gehalten werden können. Dabei ist zwischen nebeneinander von derselben Welle 28 ausgehenden Fördereinrichtungen 10, die von den Scheiben 30, 32 und 34, 36 gebildet werden, nur ein Rückhalteelement 44 oder -scheibe vorhanden.

Die Begrenzungsscheiben 42, 44, 46 sollten des Weiteren mit den jeweiligen Wangen 30, 32, 34, 36 über Stege verbunden werden. Schließlich können die Wangen 30, 32, 34, 36 sowie die Rückhaltescheiben 42, 44, 46 im erforderlichen Umfang Durchbrechungen aufweisen.

Durch die in den Figuren nicht dargestellten Öffnungen einerseits in den kreisförmigen Scheiben 30, 32, 34, 36 und andererseits in den Begrenzungselementen 42, 44, 46 ist der Vorteil gegeben, dass die Flüssigkeit 14 zum Behandeln der Gegenstände 12 beim Drehen der Einrichtung 10 seitlich abfließen kann.

Um die Gegenstände 12 der als Drehfördereinrichtung ausgebildeten Fördereinrichtung 10 zuzuführen, ist im Ausführungsbeispiel ein Riemenförderer 48 vorgesehen, über den die Gegenstände 12 - in der Darstellung gemäß Fig. 1 von links nach rechts - an einen Schlitz - im Ausführungsbeispiel den Schlitz 40- übergeben werden. Damit der Riemenförderer 48, der auch durch ein anderes Förderelement ersetzt sein kann, ohne dass die Erfindung verlassen wird, nicht in den Bereich zwischen den Wangen 30, 32 bzw. 34, 36 hinein bei der Übergabe verstellt werden muss, verläuft zwischen den Wangen 30, 32 bzw. 34, 36 ein Mitnehmer oder Schieber 50, der sowohl parallel zur Förderstrecke des Förderers 48 und eines der Dreheinrichtung 10 nachgeordneten Förderers 52 sowie vorzugsweise senkrecht oder schräg zu diesen verstellbar ist, wie die Pfeile 54 und 56 verdeutlichen sollen. Hierdurch ergibt sich die Möglichkeit, dass dann, wenn der Mitnehmer 50 im Ausführungsbeispiel nach links verschoben ist, dieser bei Parallelverschiebung entlang des Förderers 48 ein auf diesem vorhandener Gegenstand 12 in den Schlitz 40 eingebracht werden kann, der fluchtend zur Förderstrecke des Förderbandes 48 ausgerichtet sein muss. Hierzu muss der in Fig. 1 dargestellte linke Schenkel 56 ausserhalb des auf dem Förderband 48 vorhandenen Gegenstandes angeordnet und in Richtung des Förderbandes in einem Umfang abgesenkt werden, damit der Gegentand von diesem erfasst werden kann, um sodann durch Verstellen des Mitnehmers 50 in Pfeilrichtung 54 nach rechts den Gegenstand 12 in den Schlitz 40 einzubringen.

Entsprechend kann ein Gegenstand 12 von dem Schlitz 38 auf den Förderer 52 bei Ausrichtung des Schlitzes 38 auf die Förderstrecke übergeben werden, wenn der in der Darstellung rechte Schenkel 58 des Mitnehmers 50 vom inneren Ende des Schlitzes 38 ausgehend radial nach außen in Transportrichtung 54 verstellt wird, wodurch der Gegenstand 12 auf das Förderband 52 übergeben wird.

Stellen die Rückhalteelemente 42, 44, 46 sicher, dass die Gegenstände 12 sich nicht in unzulässigem Umfang axial innerhalb der Schlitze 38, 40 verschieben können, so ist als Sicherung gegen ein Herausgleiten der Gegenstände 12 aus den Schlitzen 38, 40 beim Durchlaufen des Bades 18 ein Endlosriemen 60 vorgesehen, der über Umlenkrollen 62, 64, 66, 68 derart peripher entlang des Umfangsrandes der Scheibe bzw. des Rades 30 geführt ist, dass die Schlitze 38, 40 in erforderlichem Umfang aussenseitig abgedeckt sind. Dies wird anhand der Darstellungen gemäß Fig. 1 und Fig. 2 deutlich. Der Endlosriemen 60 oder ein gleichwirkendes Element wird synchron mit der Dreheinrichtung so derart mitbewegt, dass beim Transport durch das Bad 14 zwischen den Gegenständen 12 und der Sicherung im Abstützbereich eine Relationsbewegung unterbunden ist.

Somit ist sichergestellt, dass dann, wenn die Dreheinrichtung 10, also die Scheibenelemente 30, 32, 34, 36 im Ausführungsbeispiel entgegen dem Uhrzeigersinn gedreht werden, die Gegenstände 12 nicht aus den Schlitzen 38, 40 gleiten können, wobei gleichzeitig sichergestellt ist, dass ein Beschädigen bzw. ein Zerstören der Gegenständen 12 unterbleibt.

Um eine eindeutige Fixierung des umlaufenden Riemens 60 oder gleichwirkenden Elementes sicherzustellen, sollte das Scheibenelement 30, 32, 34, 36 aussenrandseitig eine Vertiefung wie Nut aufweisen, die als Führung für den Riemen 60 dient und sicherstellt, dass dieser nicht unkontrolliert entfernt werden kann.

Antriebe der Dreheinrichtung 10 und der Sicherung bzw. des Riemens 60 können durch hinlänglich bekannte Maßnahmen synchronisiert werden. Dabei kann gegebenenfalls der Riemen 60 als Antriebsmittel für die Dreheinrichtung 10 dienen, die durch Reibschluss in Drehung versetzt werden kann.

Anstelle des Mitnehmers 50, der den Vorteil bietet, dass bei der Übergabe der Gegenstände 12 eine Verschleppung von Flüssigkeit 14 wie Chemikalien über den Transportmechanismus weitgehend unterbunden ist, können die Transportbänder 48, 52 auch entlang ihrer Transportrichtung derart verstellt werden, dass diese in erforderlichem Umfang während der Übergabe bzw. Entnahme zwischen den Scheibenelementen 30, 32 bzw. 34, 36 hineinragen, um so unmittelbar Gegenstände 12 in die Schlitze 38, 40 einzubringen bzw. von diesen zu entnehmen.

Wie die Seitenansicht der Fig. 1 verdeutlicht, sollten die Schlitze 38, 40 gleichmäßig auf dem Umfang der Scheibenelemente 30, 32, 34, 36 verteilt sein. Ein Bogenabstand von 15° kann gewählt werden. Bei einer entsprechenden Schlitzanordnung und bei der Anordnung von fünf nebeneinander, also zehn Scheibenelemente umfassenden Anordnung kann ein Durchsatz von 1000 Gegenständen 12 pro Stunde erzielt werden, wobei die Verweildauer eines jeden Gegenstandes 12 in dem Bad 16 ca. 3 min beträgt. Durch die Wahl der Drehgeschwindigkeit des Dreh- oder Kreisförderers 10, also der Scheibenelemente 30, 32 bzw. 34, 36 bzw. durch die Belegung der Schlitze 38, 40 mit Gegenständen 12 kann die Verweilzeit in der Flüssigkeit 14 in gewünschtem Umfang variiert werden.

Dem Bad 16 kann in gewohnter Weise eine Waschstufe 70 und eine Trocknungsstufe 72 nachgeordnet sein. Hierzu werden die Gegenstände 12 in der Reinigungsstufe 70 und der Trocknungsstufe 72 entlang Förderstrecken geführt, die durch Abschnitte 74, 76, 78, 80, 82, 84 gebildet werden, die wiederum Endlosförderer wie Riemenförderer oder aber auch Hubbalkensysteme sein können. Dabei sind die Gegenstände 12 in den einzelnen Abschnitten 74, 76, 78, 80 in unterschiedlichen Bereichen abgestützt, d. h., dass die Auflagepunkte innerhalb der einzelnen Teilstrecken voneinander abweichen, wodurch sichergestellt wird, dass die Gegenstände 12 vollständig gereinigt und getrocknet werden können.

Um während des Reinigens bzw. Trocknens sicherzustellen, dass die Gegenstände von dem jeweiligen Transportband nicht abheben, wirken in Richtung der Förderer 74, 76, 78, 80, 82, 84 Andruckrollen 86 auf die Gegenstände 12 ein.

Im Ausführungsbeispiel der Fig. 3 umfasst die Reinigungstufe 70 drei Bereiche 74, 76, 78, in denen die Gegenstände 12 zwischen beidseitig angebrachten Sprühdüsen 88 bzw. durch einen Flüssigkeitsschwall hindurchlaufen. In den Abschnitten 74, 76, 78 wird die verwendete Flüssigkeit in einem geschlossenen Kreislauf 90, 92, 94 gefördert. Dabei kann in dem der Förderstrecke 14 zugeordneten Abschnitt vollentsalztes Wasser, in dem anschließenden Abschnitt 76 Tensidlösung und im Abschnitt 78 erneut vollentsalztes Wasser zur Anwendung gelangen. Den jeweiligen Vorlagebehälter 96, 98, 100 sollte ferner permanent frisches, voll entsalztes Wasser zugeführt werden. Zur Wassereinsparung sind die Vorlagebehälter 96, 100, die jeweils vollentsalztes Wasser bevorraten, in Kaskade geschaltet.

Um eine Medienverschleppung zu vermeiden bzw. zu reduzieren, werden die zu behandelnden Gegenstände 12 zwischen den einzelnen Abschnitten und auch vor dem ersten Abschnitt 74 der Reinigungsstufe 70 durch zu beiden Seiten der Gegenstände angeordnete Düsen bzw. Düsenanordnungen 102 geführt, um über diese an den Gegenständen anhaftende Flüssigkeit absaugen zu können. Der hierfür erforderliche Unterdruck kann durch geeignete Aggregate, insbesondere durch Wasserstrahlpumpen erzeugt werden. Zum Absaugen der tensidhaltigen Waschlösung sollte eine Membranpumpe oder rotierende Pumpe eingesetzt werden, um ein Aufschäumen zu vermeiden.

In der Trocknungsstrecke 72 werden die Gegenstände 12 zwischen den Transportstrecken 80, 82, 84 durch Absaugeinrichtungen wie Luftmesser 102 geführt, wie rein prinzipiell in der Fig. 3 angedeutet wird.

Aufgrund der erfindungsgemäßen Lehre können problemlos plattenförmige Gegenstände 12 wie Bleche, Glasplatten, Leiterplatten oder sonstige Keramiksubstrate in notwendigem Umfang behandelt - wie Entfernen von Oxidschichten durch Abätzen - und sodann gereinigt und getrocknet werden, wobei ein kontinuierlicher Prozess gegeben ist. Dabei ist ein hoher Durchsatz erzielbar, da mit konstruktiv einfachen Maßnahmen eine Förderung der Gegenstände durch das entsprechende Flüssigkeitsbad ermöglicht wird.

## Patentansprüche

1. Verfahren zum Behandeln von scheibenförmigen Gegenständen (12) wie Blechen, Glasplatten, Leiterplatten, Keramiksubstraten, wobei die Gegenstände einem Flüssigkeit (14) enthaltenden Bad (16) zugeführt werden, mittels einer Dreheinrichtung (10) bei bleibender Ausrichtung der Gegenstände zur Drehachse (28) der Dreheinrichtung um diese gedreht und dabei durch das Bad transportiert und nach dem Bad translatorisch weggeführt werden, wobei die Gegenstände während ihres Transportes durch das Bad in in Bezug auf die Drehachse radial verlaufenden Aufnahmen (42, 44, 46) der Dreheinrichtung durch eine diese peripher umgebende Sicherung (60) zurückgehalten werden,
**dadurch gekennzeichnet,**
**dass** die Gegenstände (12) während ihres Transportes durch das Bad (16) mittels eines flexiblen Elementes (60) als Sicherung in der Aufnahme zurückgehalten werden, dass das flexible Element (60) synchron mit der Dreheinrichtung bewegt wird, dass die Gegenstände über ein Transportband (48) der Dreheinrichtung horizontal zugeführt werden, dass die Gegenstände über ein Transportband (52) von der Dreheinrichtung horizontal weggeführt und zumindest einer Wasch- und/oder Trockenstufe (70, 72) zugeführt werden und dass die Gegenstände von dem ersten Transportband an die Aufnahmen (42, 44, 46) und von diesen mittels eines Mitnehmers (50) übergeben bzw. entnommen werden, wobei der Mitnehmer parallel zur Förderrichtung des ersten und zweiten Transportbandes bewegt und angehoben und abgesenkt wird.

2. Verfahren nach Anspruch 1,
**dadurch gekennzeichnet,**
**dass** während eines parallel zur Förderrichtung des ersten und zweiten Transportbandes (48, 52) erfolgenden Bewegens des Mitnehmers (50) einer der Gegenstände (12) an eine der Aufnahmen (40) übergeben und einer der Gegenstände aus einer der Aufnahmen (38) entnommen wird.

3. Verfahren nach Anspruch 1,
**dadurch gekennzeichnet,**
**dass** die Gegenstände (12) der Drehfördereinrichtung (10) wie Wenderad über ein Transportband (48) wie Riemenförderer zugeführt und/oder in der zumindest einen Wasch- und/oder Trocknungsstufe (70, 72) translatorisch gefördert werden, wobei die Gegenstände während ihres Transports durch die Wasch- und/oder Trocknungsstufe im Bereich ihrer Transportstrecke in unterschiedlichen Bereichen abgestützt werden bzw. in der Wasch- und/oder Trocknungsstufe in Richtung ihrer Abstützung druckbeaufschlagt werden.

4. Vorrichtung zum Behandeln von scheibenförmigen Gegenständen (12) wie Blechen, Glasplatten, Leiterplatten, Keramiksubstraten, umfassend ein mit Flüssigkeit (14) befüllbares Bad (16) wie chemisches Bad zum Behandeln der Gegenstände, eine dem Bad vorgeordnete Zuführeinrichtung (48), eine die Gegenstände durch das Bad führende Fördereinrichtung (10) in Form einer Dreheinrichtung mit radial verlaufenden zur Aufnahme der Gegenstände bestimmten Aufnahmen (38, 40), eine innerhalb des Bades vorhandene Sicherung (60), die sich im peripheren Bereich der Aufnahmen zum Zurückhalten der Gegenstände in den Aufnahmen erstreckt, eine dem Bad nachgeordnete Entnahmeeinrichtung (52) sowie dem Bad nachgeordnete Wasch- und/oder Trocknungsstufe (70, 72) mit zugeordneter Transporteinrichtung (74, 76, 78, 80, 82, 84),
**dadurch gekennzeichnet,**
**dass** die Sicherung (60) ein sich synchron mit der Dreheinrichtung (10) bewegendes flexibles Element ist, dass die Zuführeinrichtung (48) ein erstes Transportband und die Entnahmeeinrichtung (52) ein zweites Transportband sind und dass parallel zur Förderrichtung des ersten und des zweiten Transportbandes ein hin- und herbewegbarer sowie anheb- und absenkbarer die Gegenstände (12) in die Aufnahmen (38, 40) aufgebender bzw. aus diesen entnehmender Mitnehmer (50) angeordnet ist.

5. Vorrichtung nach Anspruch 4,
**dadurch gekennzeichnet,**
**dass** die Dreheinrichtung (10) zwei zueinander beabstandete von einer koaxial zur Achse verlaufenden Welle (28) ausgehende Wangen (30; 32; 34, 36) mit in Bezug auf die Achse radial zur Peripherie hin geöffneten vorzugsweise gleichmäßig auf dem Umfang der Wangen verteilten Schlitzen (38, 40) als Aufnahmen umfasst, wobei insbesondere die Wangen Kreisscheiben, vorzugsweise Durchbrechungen aufweisende Kreisscheiben sind.

6. Vorrichtung nach Anspruch 5,
**dadurch gekennzeichnet,**
**dass** aussenseitig entlang jeder Wange (30, 32; 34, 36) ein von der Welle (28) ausgehendes Rückhalteelement (42, 44, 46) wie Begrenzungsscheibe verläuft, das vorzugsweise mit der jeweiligen Wange über zum Beispiel Stege verbunden ist.

7. Vorrichtung nach zumindest Anspruch 4,
**dadurch gekennzeichnet,**
**dass** das flexible Element ein Endlosriemen (60) ist, der über Umlenkrollen (62, 64, 66, 68) zum Anliegen am Umfang der Wangen (30, 32, 34; 36) geführt ist, wobei vorzugsweise die Wangen wie Kreisscheiben in ihrem Umfangsrand eine als Führung für das flexible Element dienende Vertiefung wie Nut aufweisen.

8. Vorrichtung nach zumindest einem der Ansprüche 4 - 7,
**dadurch gekennzeichnet,**
**dass** von der Welle (28) zwei Dreheinrichtungen (10) ausgehen, wobei zwischen benachbarten Wangen (32, 34) von aufeinanderfolgenden Dreheinrichtungen jeweils ein Rückhalteelement (44) verläuft.

9. Vorrichtung nach zumindest einem der Ansprüche 4 - 8,
**dadurch gekennzeichnet,**
**dass** die Zuführeinrichtung (48) und/oder die Entnahmeeinrichtung (52) eine translatorische Transporteinrichtung wie Riemenförderer ist.

10. Vorrichtung nach zumindest Anspruch 4,
**dadurch gekennzeichnet,**
**dass** der Mitnehmer (50) zwischen den Wangen (30, 32, 34, 36) der Dreheinrichtung (10) verläuft.

11. Vorrichtung nach zumindest einem der Ansprüche 4 -10,
**dadurch gekennzeichnet,**
**dass** das erste Transportband (48) und/oder das zweite Transportband (52) während der Übergabe der Gegenstände an eine der Aufnahmen (38, 40) der Dreheinrichtung bzw. während der Entnahme der Gegenstände aus diesen abschnittsweise im Bereich zwischen den Wangen (30, 32, 34, 36) der Dreheinrichtung verlaufen.

12. Vorrichtung nach zumindest einem der Ansprüche 4 - 11,
**dadurch gekennzeichnet,**
**dass** die Zuführeinrichtung (48) und/oder die Entnahmeeinrichtung (52) stirnseitig peripher beabstandet zu der Dreheinrichtung (10) verläuft.

13. Vorrichtung nach zumindest einem der Ansprüche 4 -12,
**dadurch gekennzeichnet,**
**dass** die Gegenstände (12) in der Reinigungs- und/oder Trocknungsstufe (70, 72) auf den translatorischen Fördereinrichtungen wie Riemenförderern (74, 76, 78, 80, 82, 84) oder Hubbalkenförderern angeordnet sind, wobei insbesondere die Gegenstände entlang ihrer Transportstrecke in der Reinigungs- und/oder Trocknungsstufe in unterschiedlichen Bereichen abgestützt sind.

14. Vorrichtung nach zumindest einem der Ansprüche 4 -13,
**dadurch gekennzeichnet,**
**dass** parallel zu der Transportstrecke seitliche Führungselemente für die Gegenstände (12) angeordnet sind und/oder dass die Gegenstände (12) in der Transportstrecke der Reinigungs- und/oder Trocknungsstufe (70, 72) in Richtung der Fördereinrichtung durch zum Beispiel Rollen (86) druckbeaufschlagt sind.

15. Vorrichtung nach zumindest einem der Ansprüche 4 - 14,
**dadurch gekennzeichnet,**
**dass** in der Transportstrecke der Reinigungsstufe (70) auf die Gegenstände (12) gerichtete Sprühdüsen (88) und/oder Schwalleinrichtungen angeordnet sind, wobei Reinigungsflüssigkeit in einem Kreislauf strömt, insbesondere für gleiche Reinigungsflüssigkeiten bestimmte Kreisläufe in Kaskaden geschaltet sind.

16. Vorrichtung nach zumindest einem der Ansprüche 4 - 15,
**dadurch gekennzeichnet,**
**dass** innerhalb der Reinigungsstufe (70) bzw. dieser vor- bzw. nachgeordnet Saugeinrichtungen (102) zum Absaugen von Flüssigkeit von den Gegenständen (12) angeordnet sind und/oder dass die Trocknungsstufe auf die Gegenstände ausgerichtete Luftdüsen wie -messer (102) umfasst.

## Claims

1. Method for treatment of disk-like objects (12) such as sheet metals, glass panes, printed circuit boards, ceramic substrates, where the objects are furnished to a bath (16) containing liquid (14), are by means of one rotation device (10) with a permanent alignment of the objects to the rotational axis (28) of the rotation device rotated around it and thereby passed through the bath and are led away translationally after the bath, where the objects during their passage through the bath are retained in in respect to the rotational axis radially extending receptacles (42, 44, 46) of the rotation device by means of a securing element (60) peripherally surrounding the rotation device,
**characterized in**
**that** during their passage through the bath (16) the objects (12) are retained in the receptacle by means of a flexible element (60) as securing element, that the flexible element (60) is moved synchronously with the rotation device, that the objects are furnished horizontally to the rotation device via a conveyor (48), that the objects are horizontally led away from the rotation device via a conveyor (52) and are furnished to at least one washing and/or drying stage (70, 72) and that the objects of the first conveyor are delivered to the receptacles (42, 44, 46) and from these are delivered and picked, respectively, by means of a catch element (50), where the catch element is moved in parallel to the transport direction of the first and the second conveyor and is lifted and lowered.

2. Method according to claim 1,
**characterized in**
**that** during a moving of the catch element (50) in parallel to the transport direction of the first and second conveyor (48, 52) one of the objects (12) is delivered to one of the receptacles (40) and one of the objects is picked from one of the receptacles (38).

3. Method according to claim 1,
**characterized in**
**that** the objects (12) are furnished to the rotation device (10) such as turning wheel via a conveyor (48) such as belt conveyor and/or are translationally passed in the at least one washing and/or drying stage (70, 72), where the objects are supported in the region of their transportation length in different regions during their passage through the washing and/or drying stage and, respectively, in the washing and/or drying stage are exposed to pressure in the direction of their support.

4. Device for treatment of disk-like objects (12) such as sheet metals, glass panes, printed circuit boards, ceramic substrates, comprising a bath (16) constructed and arranged to be filled with liquid (14) such as a chemical bath for treatment of the objects, a feed device (48) arranged upstream of the bath, a conveying device (10) in the form of a rotation device having radially extending receptacles (38, 40) arranged to receive the objects, a securing element (60) disposed within the bath which extends in the peripheral area of the receptacles for retaining the objects in the receptacles, a removal device (52) arranged downstream of the bath as well as a washing and/or drying stage (70, 72) with associated transport means (74, 76, 78, 80, 82, 84) arranged downstream of the bath,
**characterized in**
**that** the securing element (60) is a flexible element moving synchronously with the rotation device (10), that the feed device (48) is a first conveyor and the removal device is a second conveyor, and that a catch element (50) is arranged in parallel to the transportation direction of the first and the second conveyor, said catch element being adapted to reciprocate as well as to lift and to lower and furnishing the objects (12) to and picking them from, respectively, the receptacles (38,40).

5. Device according to claim 4,
**characterized in**
**that** the rotation device (10) comprises two cheeks (30, 32; 34, 36) spaced from another and originating from a shaft (28) extending coaxially to the axis, said cheeks having slots (38, 40) extending radially in respect to the axis and being opened radially peripherally and preferably being evenly distributed on the circumference of the cheeks, where the cheeks are especially circular disks, particularly circular disks showing penetrations.

6. Device according to claim 5,
**characterized in**
**that** on the outside along each cheek (30, 32; 34, 36) a retaining element (42, 44, 46) such as a limiting disk originating from the shaft (28) extends, that preferably is connected to the respective cheek for instance via webs.

7. Device according to at least claim 4,
**characterized in**
**that** the flexible element is an endless belt (60), which is guided via deflecting rollers (62, 64, 66, 68) for sitting close to the circumference of the cheeks (30, 32, 34, 36), where preferably the cheeks such as circular disks have a deepening such as groove in their circumferential edge serving as guidance for the flexible element.

8. Device according to at least one of the claims 4 - 7,
**characterized in**
**that** two rotation devices (10) origin from the shaft (28), where between adjacent cheeks (32, 34) of consecutive rotation devices one retaining element (44) each extends.

9. Device according to at least one of the claims 4 - 8,
**characterized in**
**that** the feed device (48) and/or the removal device (52) is a translational transportation device such as belt conveyor.

10. Device according to at least claim 4,
**characterized in**
**that** the catch element (50) extends between the cheeks (30, 32, 34, 36) of the rotation device (10).

11. Device according to at least one of the claims 4 - 10,
**characterized in**
**that** the first conveyor (48) and/or the second conveyor (52) extends in sections in the region between the cheeks (30, 32, 34, 3, 36) of the rotation device during the delivery of the objects to one of the receptacles (38, 40) of the rotation device and, respectively, during the picking of the objects from these.

12. Device according to at least one of the claims 4 - 11,
**characterized in**
**that** the feed device (48) and/or the removal device (52) extends on the face peripherally spaced to the rotation device (10).

13. Device according to at least one of the claims 4 - 12,
**characterized in**
**that** the objects (12) in the cleaning and/or drying stage (70, 72) are arranged on the translational transportation devices such as belt conveyors (74, 76, 78, 80, 82, 84) or walking beam conveyors, where particularly the objects along their transportation length in the cleaning and/or drying stage are supported in different regions.

14. Device according to at least one of the claims 4 - 13,
**characterized in**
**that** lateral guiding elements for the objects are arranged in parallel to the transportation length and/or that the objects (12) are exposed to pressure, for instance by rollers (86), in the transportation length of the cleaning and/or drying stage (70, 72) in direction of the transportation device.

15. Device according to at least one of the claims 4 - 14,
**characterized in**
**that** spray nozzles (88) and/or surge cleaning devices directed toward the objects (12) are arranged in the transportation length of the cleaning stage (70), where cleansing liquor flows in a circuit, especially circuits for identical cleansing liquor are connected in cascades.

16. Device according to at least one of the claims 4 - 15,
**characterized in**
**that** suction devices (102) for extraction of liquid from the objects (12) are disposed inside the cleaning stage (70) and, respectively, upstream and, respectively, downstream thereof and/or that the drying stage comprises air jets such as knives (102) directed toward the objects.

## Revendications

1. Procédé de traitement d'objets en forme de tranches (12), comme des tôles, vitres, circuits imprimés, substrats céramiques, selon lequel les objets sont amenés à un bain (16) contenant un liquide (14), sont tournés au moyen d'un dispositif rotatif (10), avec orientation constante des objets par rapport à l'axe de rotation (28) du dispositif rotatif, autour de cet axe et sont ainsi transportés à travers le bain et, après le bain, évacués par translation, les objets étant logés, pendant leur transport à travers le bain dans des logements (42, 44, 46) du dispositif rotatif disposés radialement par rapport à l'axe de rotation, et retenus par un dispositif de sécurité (60) entourant ceux-ci de manière périphérique,
**caractérisé en ce que**
les objets (12), pendant leur transport à travers le bain, (16) sont retenus dans le logement au moyen d'un élément flexible (60) en tant que dispositif de sécurité, l'élément flexible (60) se déplace de manière synchrone avec le dispositif rotatif, les objets sont amenés horizontalement au dispositif rotatif par une bande transporteuse (48), les objets sont évacués horizontalement du dispositif rotatif par une bande transporteuse (52) et sont amenés au moins à un étage de lavage et/ou de séchage (70, 72), et les objets sont transférés de la première bande transporteuse aux logements (42, 44, 46) et enlevés de ceux-ci au moyen d'un entraîneur (50), déplacé, levé et baissé parallèlement à la direction de transport de la première et de la seconde bandes transporteuses.

2. Procédé selon la revendication 1,
**caractérisé en ce que**
pendant un déplacement de l'entraîneur (50) s'effectuant parallèlement à la direction de transport de la première et de la seconde bandes transporteuses (48, 52), l'un des objets (12) est transmis à l'un des logements (40) et l'un des objets est prélevé de l'un des logements (38).

3. Procédé selon la revendication 1,
**caractérisé en ce que**
les objets (12) sont amenés au dispositif rotatif (10), tel qu'une roue d'inversion, par une bande transporteuse (48), comme un transporteur à courroies, et/ou sont transportés par translation dans l'au moins un étage de lavage et/ou de séchage (70, 72), les objets étant, pendant leur transport à travers l'étage de lavage et/ou de séchage, appuyés dans la zone de leur parcours de transport dans différentes zones et étant sollicités par la pression dans l'étage de lavage et/ou de séchage dans la direction de leur appui.

4. Dispositif pour le traitement d'objets en forme de tranches (12), comme des tôles, vitres, circuits imprimés, substrats céramiques, comprenant un bain (16) remplissable d'un liquide (14), tel que bain chimique pour le traitement des objets, un dispositif d'amenée (48) disposé en amont du bain, un dispositif de transport (10) guidant les objets à travers le bain, en forme de dispositif rotatif agent des logements (38, 40) disposés radialement, destinés à la réception des objets, un dispositif de sécurité (60) présent à l'intérieur du bain, qui s'étend dans la zone périphérique des logements pour la retenue des objets dans ceux-ci, un dispositif de prélèvement (52) situé en aval du bain, ainsi que des étages de lavage et/ou séchage (70, 72) en aval du bain, avec dispositif de transport associé (74, 76, 78, 80, 82, 84),
**caractérisé en ce que**
le dispositif de sécurité (60) est un élément flexible se déplaçant de manière synchrone avec le dispositif rotatif (10), le dispositif d'amenée (48) est une première bande transporteuse et le dispositif de prélèvement (52) une seconde bande transporteuse, et un entraîneur (50) effectuant un mouvement de va-et-vient ainsi que de levée et de descente, délivrant les objets (12) dans les logement (38, 40) et les prélevant de ceux-ci, est disposé parallèlement à la direction de transport de la première et de la seconde bandes transporteuses.

5. Dispositif selon la revendication 4,
**caractérisé en ce que**
le dispositif rotatif (10) comprend deux joues (30, 32 ; 34, 36) situées à distance l'une par rapport à l'autre, partant d'un arbre (28) disposé coaxialement par rapport à l'axe, comportant comme logements des fentes (38, 40), ouvertes, par rapport à l'axe, radialement vers la périphérie, réparties de préférence régulièrement sur la périphérie des joues, les joues étant en particulier des disques, de préférence des disques présentant des passages transversants.

6. Dispositif selon la revendication 5,
**caractérisé en ce qu'**
un élément de retenue (42, 44, 46), comme un disque de limitation, partant de l'arbre (28), et relié de préférence avec la joue respective par des tiges par exemple, est disposé du coté extérieur le long de chaque joue (30, 32 ; 34, 36).

7. Dispositif selon au moins la revendication 4,
**caractérisé en ce que**
l'élément flexible est une courroie sans fin (60) guidée par des poulies de renvoi (62, 64, 66, 68) pour appui contre la périphérie des joues (30, 32, 34, 36), et les joues, telles que des disques, présentent de préférence dans leur bord périphérique un creux, comme une rainure, servant de guidage de l'élément flexible.

8. Dispositif selon au moins l'une des revendications 4 - 7,
**caractérisé en ce que**
de l'arbre (28) partent deux dispositifs rotatifs (10) et un élément de retenue (44) est disposé respectivement entre des joues voisines (32, 34) de dispositifs rotatifs consécutifs.

9. Dispositif selon au moins l'une des revendications 4 - 8,
**caractérisé en ce que**
le dispositif d'amenée (48) et/ou le dispositif de prélèvement (52) est un dispositif de transport par translation, comme un transporteur à courroie.

10. Dispositif selon au moins la revendication 4,
**caractérisé en ce que**
l'entraîneur (50) est disposé entre les joues (30, 32 ; 34, 36) du dispositif rotatif (10).

11. Dispositif selon au moins l'une des revendications 4 - 10,
**caractérisé en ce que**
la première bande transporteuse (48) et/ou la seconde bande transporteuse (52), pendant le transfert des objets à l'un des logements (38, 40) du dispositif rotatif et pendant le prélèvement des objets hors de ceux-ci, se déplacent par segments dans la zone entre les joues (30, 32 ; 34, 36).

12. Dispositif selon au moins l'une des revendications 4 - 11,
**caractérisé en ce que**
le dispositif d'amenée (48) et/ou le dispositif de prélèvement (52) est disposé du côté frontal, à distance, du côté périphérique, par rapport au dispositif rotatif (10).

13. Dispositif selon au moins l'une des revendications 4 - 12,
**caractérisé en ce que**
les objets (12), dans l'étage de nettoyage et/ou de séchage (70, 72), sont disposés sur les dispositifs de transport par translation tels que transporteurs à courroie (74, 76, 78, 80, 82, 84) ou transporteurs à longerons mobiles, et les objets, en particulier le long de leur parcours de transport dans l'étage de nettoyage et/ou de séchage, sont appuyés dans différentes zones.

14. Dispositif selon au moins l'une des revendications 4 - 13,
**caractérisé en ce que**
des éléments de guidage latéraux pour les objets (12) sont disposés parallèlement au parcours de transport et/ou les objets (12), dans le parcours de transport de l'étage de nettoyage et/ou de séchage (70, 72), sont sollicités par la pression dans la direction du dispositif de transport, par exemple par des galets (86).

15. Dispositif selon au moins l'une des revendications 4 - 14,
**caractérisé en ce que**
des buses de pulvérisation (88) et/ou des dispositifs à jet d'eau dirigés sur les objets (12) sont disposés dans le parcours de transport de l'étage de nettoyage (70), le liquide de nettoyage s'écoule dans un circuit, certains circuits étant montés en cascades en particulier pour les mêmes liquides de nettoyage.

16. Dispositif selon au moins l'une des revendications 4 - 15,
**caractérisé en ce que**
des dispositifs d'aspiration (102) pour l'aspiration de liquide des objets (12) sont disposés à l'intérieur de l'étage de nettoyage (70) ou en amont ou en aval de celui-ci, et/ou l'étage de séchage comprend des buses à air telles qu'un manomètre (102) dirigées sur les objets, telles que des larmes d'air (102).
